# EUROPÄISCHE PATENTSCHRIFT

(11) **EP 2 204 909 B1**
(45) Veröffentlichungstag und Bekanntmachung des Hinweises auf die Patenterteilung: **12.04.2017**
(21) Anmeldenummer: 09011563.5
(22) Anmeldetag: 09.09.2009
(51) Int. Cl.: H03K 17/96

(54) **Berührungsempfindlicher Gleitschalter**
Touch-sensitive slide switch
Commutateur coulissant sensible au contact

(30) Priorität: 05.01.2009 DE 202009000139 U
(43) Veröffentlichungstag der Anmeldung: 07.07.2010
(73) Patentinhaber: Irlbacher Blickpunkt Glas GmbH, 92539 Schönsee (DE)
(72) Erfinder: Günther Irlbacher, 92539 Schönsee (DE)
(74) Vertreter: Grünecker Patent- und Rechtsanwälte PartG mbB

(56) Entgegenhaltungen:
- EP-A1- 0 930 806
- EP-A2- 1 273 851
- CN-Y- 201 163 358
- US-A1- 2005 052 426
- US-A1- 2005 134 116

## Beschreibung

Die vorliegende Erfindung betrifft einen berührungsempfindlichen Gleitschalter mit einer Schaltfläche, die haptische Merkmale aufweist, wobei der Gleitschalter derart ausgebildet ist, dass er eine Berührung und/oder Bewegung auf der Schaltfläche in ein elektrisches Signal umwandelt.

Derartige Gleitschalter werden dort eingesetzt, wo die kontinuierliche Einstellbarkeit eines Betriebsparameters gefordert ist. Üblicherweise werden solche Gleitschalter bedient, indem ein Benutzer einen Finger auf die Schaltfläche des Gleitschalters legt und entlang der Schaltfläche bewegt.

Aus der EP 1 876 394 A2 ist ein Gleitstreifen für einen Herd bekannt, der zum Einstellen der Kochstufe oder einer Timerfunktion dient. Der Gleitstreifen soll eine präzise Einstellung des gewünschten Parameters ermöglichen. Dazu ist vorgesehen, dass eine Bedienoberfläche des Gleitstreifens eine haptisch wirksame Strukturierung aufweist. Vorzugsweise ist die Bedienoberfläche des Gleitstreifens mit Querlinien bedruckt, die einen im Wesentlichen gleichen Abstand voneinander aufweisen. Die Bedienoberfläche des Gleitstreifens ist also aufgeraut, so dass ein höherer Gleitwiderstand entsteht. Dadurch wird eine bessere Einstellbarkeit erzielt. Eine Anzeige zeigt den Wert des gerade aktiven Betriebsparameters an.

Die EP 1 273 851 A2 zeigt eine Stelleinheit für Gargeräte mit einem berührungsempfindlichen Stellstreifen. Der Stellstreifen ist optisch durch eine Keilform dargestellt.

Aus der US 2005/052426 A1 und der US 2005/0134116 A1 sind Tastschalter für Pkws bekannt, die hinter einer Oberfläche angeordnet sind und wobei die Oberfläche im Bereich der Tastschalter mit einem Relief versehen ist.

Die EP 0 930 806 A1 zeigt eine Glaskeramikkochplatte mit einem Schalter, der durch ein Relief gekennzeichnet ist.

Die CN 201 163 358 Y zeigt einen berührungsempfindlichen Gleitschalter zum Einstellen der Helligkeit einer Leuchte bzw. der Geschwindigkeit eines Ventilators.

Die Aufgabe der vorliegenden Erfindung ist es, einen Gleitschalter mit verbesserter Benutzerführung bereitzustellen.

Hierzu ist erfindungsgemäß vorgesehen, dass die haptischen Merkmale auf der Schaltfläche als Positionsmarkierungen ausgebildet sind und mindestens zwei Positionsmarkierungen haptische Unterschiede aufweisen.

Durch die Anordnung der haptischen Merkmale auf der Schaltfläche entsteht ein fühlbares Relief, das die Positionsmarkierungen ausbildet. Ein Benutzer erkennt also anhand dieses Reliefs, an welcher Position des Gleitschalters er sich befindet und muss zur Benutzung des Gleitschalters nicht auf den Gleitschalter blicken. Ein solcher Gleitschalter ist daher auch für Sehbehinderte gut zu bedienen. Die unterschiedlichen Positionsmarkierungen können beispielsweise durch unterschiedliche Formen der haptischen Merkmale oder durch die Kombination verschiedener haptischer Merkmale ausgebildet sein. Beispiele für die Ausbildung der haptischen Merkmale sind Vertiefungen, Erhöhungen, Rippen, Rillen, Punkte, unterschiedliche Oberflächenrauhigkeiten oder Ähnliches.

In einer Ausgestaltung kann vorgesehen sein, dass die Positionsmarkierungen auf der Schaltfläche entlang der Längserstreckung der Schaltfläche zunehmende haptische Unterschiede aufweisen. Mit dem Begriff Längserstreckung ist hierbei die Richtung der Schaltfläche bezeichnet, in der die Schaltbewegung, also z. B. das Hin- und Herbewegen eines Fingers, stattfindet. Da die Positionsmarkierungen in der Längserstreckung der Schaltfläche zunehmende Unterschiede aufweisen, dienen sie als Richtungsanzeige. Der Benutzer erkennt ohne auf den Gleitschalter zu blicken und nur durch Ertasten, in welche Richtung der Schaltfläche er den Finger bewegt und ob er eine Erhöhung des Schaltsignals oder eine Verringerung des Schaltsignals bewirkt.

Vorzugsweise kann vorgesehen werden, dass der Abstand zwischen den haptischen Merkmalen auf der Schaltfläche entlang der Längserstreckung der Schaltfläche abnimmt. Somit nimmt also die Dichte der haptischen Merkmale entlang der Längserstreckungen der Schaltfläche zu. Dadurch wird eine einfache Ausbildung der Richtungsanzeige ermöglicht.

Noch eine weitere Ausgestaltung sieht vor, dass die Größe der haptischen Merkmalen auf der Schaltfläche entlang der Längserstreckung der Schaltfläche zunimmt. Auch hierdurch wird eine einfache Richtungsanzeige ermöglicht. Es ist auch eine Kombination von Abstandsverringerung und Vergrößerung der haptischen Merkmale möglich.

In einer Variante ist vorgesehen, dass die Position der Schaltfläche an dem Gleitschalter mittels Leuchtdioden gekennzeichnet ist. Die Leuchtdioden zeigen also an, an welcher Stelle des Gleitschalters sich die Schaltfläche befindet. Für einen Benutzer ist somit ersichtlich, an welcher Stelle er den Gleitschalter berühren muss, um einen Schaltvorgang auszulösen. Die Leuchtdioden können dabei beispielsweise benachbart zu der Schaltfläche bzw. unterhalb der Schaltfläche an dem Gleitschalter angeordnet sein. Es ist aber auch denkbar, die Leuchtdioden unmittelbar hinter der Schaltfläche an dem Gleitschalter anzuordnen.

Vorteilhafterweise kann die Schaltfläche in Bereiche aufgeteilt sein, denen jeweils mindestens eine Leuchtdiode zugeordnet ist, und wobei die Leuchtdioden bei Berührung der zugeordneten Bereiche der Schaltfläche ihre Farbe wechseln. Der Benutzer erkennt dadurch, wo er den Gleitschalter bereits bedient hat. Bei Unterbrechung des Schaltvorgangs weiß der Benutzer, an welcher Position er wieder ansetzen muss, wenn er den Schaltvorgang fortführen möchte.

In noch einer weiteren Ausführungsform kann vorgesehen sein, dass in die Schaltfläche berührungsempfindliche Tasten integriert sind. Somit ist eine Bedienung der Tasten ohne Verlassen des Gleitschalters möglich. Dadurch wird eine einfache Abgabe von Sonderbefehlen ermöglicht. Die Tasten sind vorzugsweise ebenfalls als berührungsempfindliche Sensoren ausgebildet. Der Gleitschalter weist also eine geschlossene Oberfläche auf, so dass keine Verunreinigungen in den Schalter eindringen können.

Zweckmäßigerweise weist die Position der Tasten in der Schaltfläche eine Kennzeichnung auf. Dadurch wird ein einfaches Auffinden der Tasten möglich. Als Kennzeichnung können beispielsweise ebenfalls Leuchtdioden oder farbige Kennzeichnungen vorgesehen sein. Es sind auch Kombinationen dieser Kennzeichnungen möglich.

In einer besonders bevorzugten Ausgestaltung ist vorgesehen, dass die Position der Tasten in der Schaltfläche eine haptische Kennzeichnung aufweist. In diesem Fall können auch die Tasten von dem Benutzer ohne Hinsehen erkannt werden. Dabei können die Positionsmarkierungen gleichzeitig als Markierungen für die Tasten ausgebildet sein. Ebenso ist es möglich, dass die Positionsmarkierungen auf der Schaltfläche und die Kennzeichnungen der Tasten durch separate haptische Merkmale ausgebildet sind.

Noch eine weitere Ausgestaltung sieht vor, dass die Schaltfläche auf der Vorderseite einer Grundplatte des Gleitschalters angeordnet ist und die Schaltfläche von der Vorderseite der Grundplatte hervorgehoben ist. Dadurch kann die Schaltfläche des Gleitschalters leicht ertastet werden.

In einer besonders bevorzugten Ausgestaltung kann die Schaltfläche als Vertiefung in der Grundplatte ausgebildet sein. Dadurch ist eine sehr einfache Ausgestaltung und Fertigung der Schaltfläche, z. B. durch Fräsen, möglich. Zudem wird der Finger des Benutzers bei der Betätigung des Gleitschalters in der Schaltfläche geführt.

In einer Variante kann vorgesehen sein, dass die Schaltfläche als umlaufende Gleitbahn ausgebildet ist. Mögliche Formen der Gleitbahn sind eine Kreisbahn, eine ovale Bahn, eine quadratische Bahn, eine dreieckige Bahn oder andere geschlossene Formen. Dadurch wird ein einfaches kontinuierliches Schalten ermöglicht.

Es kann aber auch vorgesehen sein, dass die Schaltfläche als beidseitig begrenzte Gleitstrecke ausgebildet ist. Die Schaltfläche kann beispielsweise als Kreisringsegment oder als eine Gerade ausgebildet sein. Die Schaltfläche weist dann einen definierten Startpunkt und einen definierten Endpunkt auf, die beispielsweise eine Aus-Stellung und einen Maximalwert des einzustellenden Parameters festlegen.

Im Folgenden wird die Erfindung anhand von Zeichnungen näher erläutert. Es zeigen:
- Fig. 1: Draufsicht auf eine erste Ausführungsform eines Gleitschalters,
- Fig. 2: Schnitt durch den Gleitschalter aus Fig. 1 entlang der Linie II-II,
- Fig. 3: Draufsicht auf eine Variante des Gleitschalters,
- Fig. 4: Querschnitt durch eine weitere Variante eines Gleitschalters senkrecht zur Längsrichtung,
- Fig. 5: Draufsicht auf eine weitere Ausführungsform eines Gleitschalters,
- Fig. 6: Schnitt durch den Gleitschalter aus Fig. 5 entlang der Linie VI-VI,
- Fig. 7: Draufsicht auf eine weitere Ausführungsform eines Gleitschalters,
- Fig. 8: Schnitt durch den Gleitschalter aus Fig. 7 entlang der Linie VIII-VIII,
- Fig. 9: Draufsicht auf noch eine weitere Ausführungsform eines Gleitschalters und
- Fig. 10: Schnitt durch den Gleitschalter aus Fig. 9 entlang Linie X-X.

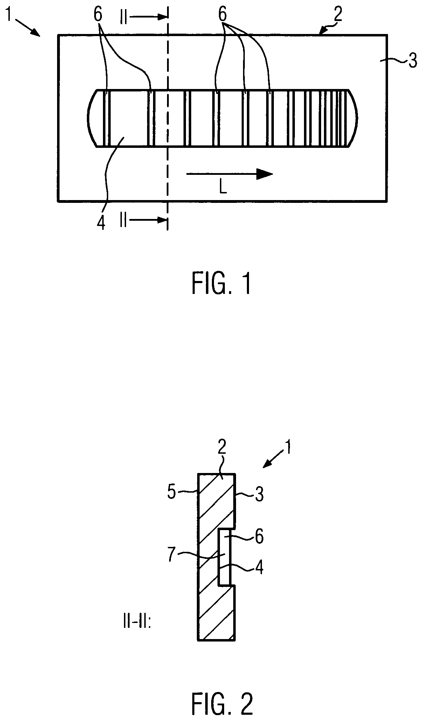

Fig. 1 zeigt eine Draufsicht auf eine erste Ausführungsform eines Gleitschalters 1. Der Gleitschalter 1 umfasst eine Grundplatte 2 mit einer Vorderseite 3 und einer Rückseite 5. Als Material wird für die Grundplatte 2 vorzugsweise ein biegesteifes Material eingesetzt. Beispiele hierfür sind Glas, Glaskeramik, Kunststoff oder Metall. Auf der Vorderseite 3 der Grundplatte 2 weist der Gleitschalter 1 eine Schaltfläche 4 auf. Die Schaltfläche 4 hat die Form einer langgestreckten Fläche, z.B. eines langgestreckten Rechtecks und ist somit als beidseitig begrenzte Gleitstrecke ausgebildet. Auf der Rückseite 5 der Grundplatte 2 ist an einem der Schaltfläche 4 zugeordneten Bereich das Elektronikmodul bzw. der Messaufnehmer angebracht, der eine Berührung der Schaltfläche 4 beispielsweise mit einem Finger und eine Bewegung eines Fingers auf der Schaltfläche 4 in ein elektrisches Signal umwandelt. Beispiele für den Messaufnehmer können ein kapazitiver Sensor, ein induktiver Sensor, ein resistiver Sensor oder Ähnliches sein.

Auf der Schaltfläche 4 sind Querrippen 6 als haptische Merkmale angebracht. Die Querrippen 6 verlaufen quer zur Längserstreckung L der Schaltfläche 4. Die Querrippen 6 stehen von der Schaltfläche 4 vor. Durch die Querrippen 6 und die Schaltfläche 4 entsteht somit ein Relief, das ein Benutzer ertasten kann. Der Abstand zwischen zwei benachbarten Querrippen 6 nimmt auf der Schaltfläche 4 von links nach rechts ab. Ist der Abstand zwischen zwei benachbarten Querrippen 6 groß, erkennt der Benutzer, dass er sich im linken Bereich der Schaltfläche 4 des Gleitschalters 1 befindet. Mit abnehmendem Abstand zwischen den Querrippen 6 bemerkt der Benutzer, dass er sich auf der Schaltfläche 4 entlang der Längsrichtung L der Schaltfläche 4 nach rechts bewegt. Durch die Querrippen 6 und die zwischen ihnen ausgebildeten Abstände werden daher Positionsmarkierungen ausgebildet. Da sich der Abstand zwischen den Querrippen 6 in Längsrichtung L der Schaltfläche 4 verändert, sind an verschiedenen Positionen der Schaltfläche 4 unterschiedliche Positionsmarkierungen ausgebildet. Ein Benutzer des Gleitschalters 1 erkennt also allein durch Ertasten, an welcher Position des Gleitschalters 1 sich sein Finger befindet. Durch die abnehmenden Abstände zwischen den Querrippen 6 entlang der Längserstreckung L erkennt der Benutzer auch, in welche Richtung er sich auf der Schaltfläche 4 bewegt und ob er somit den Sollwert für den einzustellenden Parameter erhöht oder verringert. Wie in Fig. 1 zu erkennen, sind die Querrippen entlang der Längserstreckung L der Schaltfläche 4 identisch ausgebildet. Die Querrippen weisen also die gleiche Länge, die gleiche Breite und die gleiche Höhe auf. Lediglich der Abstand zwischen den Querrippen 6 wird variiert.

In Fig. 2 ist ein Schnitt durch den Gleitschalter 1 aus Fig. 1 entlang der Linie II-II dargestellt. Die Schaltfläche 4 ist durch eine Vertiefung 7 in der Grundplatte 2 ausgebildet. Dadurch kann ein Benutzer die Schaltfläche 4 bei einem Überstreichen der Vorderseite 3 der Grundplatte 2 leicht ertasten. Es kann aber auch vorgesehen werden, dass die Schaltfläche als Erhöhung auf der Vorderseite der Grundplatte oder lediglich durch einen Aufdruck auf der Grundplatte ausgebildet ist.

Auf der Schaltfläche 4 sind die Querrippen 6 angeordnet. Die Querrippen 6 stehen über die Schaltfläche 4 vor, so dass sie ein Benutzer beim Überstreichen mit dem Finger gut ertasten kann. Die Querrippen 6 weisen eine geringere Höhe auf als die Tiefe der Vertiefung 7. Somit sind die Querrippen 6 von der Vorderseite 3 der Grundplatte 2 zurückgesetzt und gut geschützt.

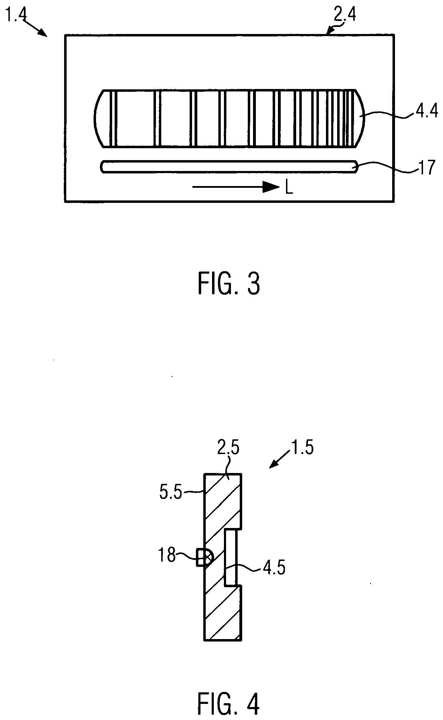

Eine Variante des Gleitschalters ist in Fig. 3 gezeigt. Der Gleitschalter 1.4 umfasst ebenfalls eine Grundplatte 2.4, auf deren Vorderseite die Schaltfläche 4.4 ausgebildet ist. Der Gleitschalter 1.4 ist im Wesentlichen so aufgebaut, wie die bereits beschriebenen Gleitschalter. Im Folgenden werden daher nur die Unterschiede aufgeführt. In der Grundplatte 2.4 des Gleitschalters 1.4 ist unterhalb der Schaltfläche 4.4 eine Leuchtdiodenleiste 17 angeordnet. Die Leuchtdiodenleiste 17 setzt sich aus einzelnen Leuchtdioden zusammen. Die Länge der Leuchtdiodenleiste 17 entspricht in etwa der Länge der Schaltfläche 4.4. Die Leuchtdiodenleiste 17 ist also der Schaltfläche 4.4 zugeordnet, so dass die Position der Schaltfläche 4.4 an dem Gleitschalter 1.4 mittels der Leuchtdioden der Leuchtdiodenleiste 17 gekennzeichnet ist.

In Fig. 4 ist eine weitere Alternative eines Gleitschalters 1.5 dargestellt. Fig. 4 zeigt einen Querschnitt durch einen Gleitschalter 1.5. Auch der Gleitschalter 1.5 ist im Wesentlichen so aufgebaut, wie die bereits beschriebenen Gleitschalter. Im Folgenden werden daher nur die Unterschiede aufgezeigt. Der Gleitschalter 1.5 umfasst ebenfalls eine Grundplatte 2.5, die eine Schaltfläche 4.5 aufweist. Die Position der Schaltfläche 4.5 in der Grundplatte 2.5 des Gleitschalters 1.5 wird mittels Leuchtdioden 18 gekennzeichnet. Dabei sind die Leuchtdioden 18 in der Grundplatte 2.5 des Gleitschalters 1.5 hinter der Schaltfläche 4.5 im Bereich der Schaltfläche 4.5 angeordnet. Die Leuchtdioden 18 sind also auf der Rückseite 5.5 der Grundplatte 2.5 des Gleitschalters 1.5 befestigt.

Vorzugsweise sind die Leuchtdioden der Leuchtdiodenleiste 17 und die Leuchtdioden 18 des in Fig. 4 gezeigten Gleitschalters 1.5 so ausgebildet, dass sie ihre Farbe wechseln können. Die Leuchtdioden der Leuchtdiodenleiste 17 sind so unterhalb der Schaltfläche 4.4 des Gleitschalters 1.4 angeordnet, dass sie einzelnen Bereichen der Schaltfläche 4.4 zugeordnet werden können. Ferner sind die Leuchtdioden der Leuchtdiodenleiste 17 so ausgebildet, dass sie ihre Farbe wechseln, wenn der zugeordnete Bereich der Schaltfläche 4.4 berührt wird. Somit kann ein Benutzer erkennen, welchen Bereich der Schaltfläche er bereits überstrichen hat und nach einer Unterbrechung des Schaltvorgangs kann der Schaltvorgang an der markierten Stelle, d.h. dort, wo der Farbwechsel der Leuchtdioden aufhört, wieder aufgenommen werden.

Auch die Leuchtdioden 18 des in Fig. 4 gezeigten Gleitschalters 1.5 sind einzelnen Bereichen der Schaltfläche 4.5 zugeordnet. Werden diese Bereiche der Schaltfläche 4.5 von einem Benutzer berührt, so wechseln die Leuchtdioden 18 vorzugsweise ihre Farben. Auch hier kann ein Benutzer also erkennen, wo er den Gleitschalter bereits berührt hat und weiß eventuell auch wo er bei der weiteren Bedienung wieder ansetzen muss.

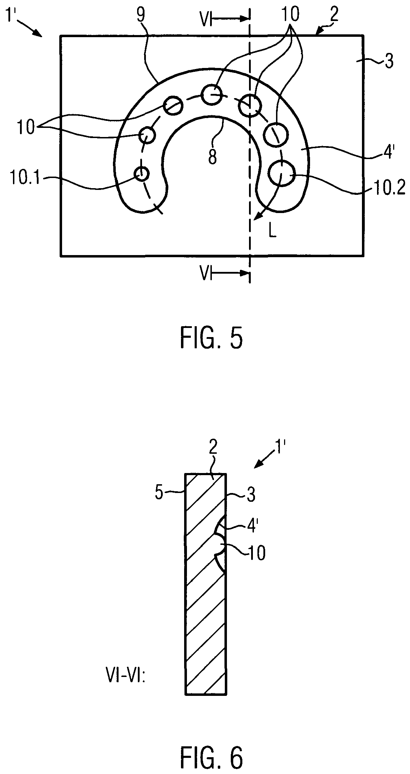

In Fig. 5 ist eine weitere Ausführungsform eines Gleitschalters 1' gezeigt. Dieser Gleitschalter 1' ist ähnlich wie die vorgehend beschriebenen Gleitschalter aufgebaut. Im Folgenden werden daher im Wesentlichen die Unterschiede aufgezeigt. Der Gleitschalter 1' umfasst ebenfalls eine Grundplatte 2, an deren Rückseite 5 die benötigten Elektronikmodule angebracht sind. Der Übersichtlichkeit halber sind diese Module nicht dargestellt.

Die Schaltfläche 4' des Gleitschalters 1' ist als Kreisringsegment bzw. hufeisenförmig ausgebildet. Auch hier ist die Schaltfläche 4' also als beidseitig begrenzte Gleitstrecke ausgebildet. Der Vorteil hierbei besteht darin, dass die Schaltfläche 4, 4' einen definierten Anfangspunkt und einen definierten Endpunkt aufweist, die Grenzwerte für den einzustellenden Parameter, beispielsweise eine Aus-Stellung und einen Maximalwert, festlegen.

Mit Längserstreckung L wird bei dieser Ausführungsform des Gleitschalters 1' die Richtung entlang der Mittellinie zwischen dem inneren Kreisbogen 8 und dem äußeren Kreisbogen 9 des Kreissegments bezeichnet. Die haptischen Merkmale sind als kugelsegmentförmige Vorsprünge 10, 10.1, 10.2 an der Schaltfläche 4' ausgebildet. Die kugelsegmentförmigen Vorsprünge 10, 10.1, 10.2 weisen vorzugsweise einen konstanten Abstand voneinander auf. Die Größe der kugelsegmentförmigen Vorsprünge 10, 10.1, 10.2 nimmt in Längsrichtung L der Schaltfläche 4' zu. Somit ist der am linken Ende der Schaltfläche 4' ausgebildete kugelsegmentförmige Vorsprung 10.1 kleiner als der am rechten Ende ausgebildete kugelsegmentförmige Vorsprung 10.2. Auch in diesem Fall sind die haptischen Merkmale, also die kugelsegmentförmigen Vorsprünge 10, 10.1, 10.2 daher als Positionsmarkierungen ausgebildet, wobei unterschiedliche Positionen durch unterschiedliche Größe der kugelsegmentförmigen Vorsprünge 10, 10.1, 10.2 gekennzeichnet werden. Da die Größe der kugelsegmentförmigen Vorsprünge 10, 10.1, 10.2 in Längsrichtung L der Schaltfläche 4' zunimmt, bilden die haptischen Merkmale eine Richtungsanzeige aus, so dass der Benutzer erkennt, ob durch die Bewegung seines Fingers auf der Schaltfläche 4' des Gleitschalters 1' der Sollwert des einzustellenden Parameters erhöht oder verringert wird.

In Fig. 6 ist ein Schnitt durch den Gleitschalter 1' aus Fig. 5 entlang der Linie VI-VI dargestellt. Auch in diesem Fall ist die Grundplatte 2 vorzugsweise aus einem biegesteifen Material wie Glas, Keramik, Glaskeramik oder Metall ausgebildet. Die Schaltfläche 4' wird durch eine Vertiefung in der Vorderseite 3 der Grundplatte 2 ausgebildet. Beispielsweise kann dies eine Einfräsung sein. Die kugelsegmentförmigen Vorsprünge 10 werden durch das Material der Grundplatte 2 ausgebildet. Es kann auch vorgesehen werden, dass die kugelsegmentförmigen Vorsprünge als separate Teile auf die Grundplatte aufgesetzt werden und beispielsweise durch Kleben oder eine anderweitig an der Grundplatte befestigt sind.

Es kann auch vorgesehen werden, die haptischen Merkmale durch Vorsprünge mit anderem Querschnitt oder durch Vertiefungen wie Bohrungen oder Rillen auszubilden. Alternativ kann die Oberfläche der Schaltfläche unterschiedliche Oberflächenrauhigkeiten aufweist. Beispielsweise kann vorgesehen werden, dass die Oberflächenrauhigkeit der Schaltfläche in Längserstreckung der Schaltfläche zunimmt. Um eine Richtungsanzeige zu ermöglichen kann auch vorgesehen werden, dass die Anzahl der haptischen Merkmale an der jeweiligen Position erhöht wird. Somit muss die Größe der haptischen Merkmale oder der Abstand der haptischen Merkmale voneinander nicht geändert werden.

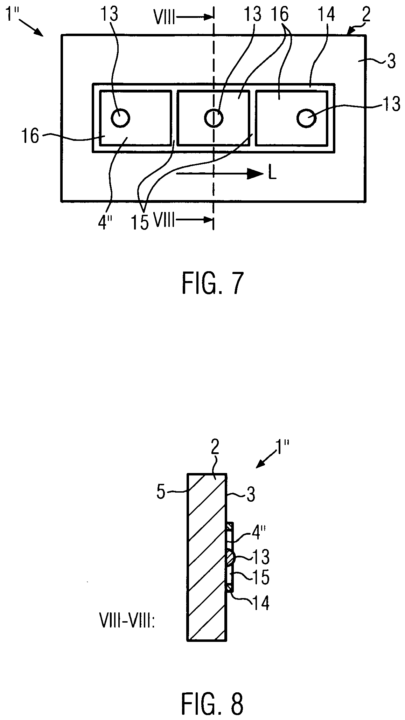

Fig. 7 und Fig. 8 zeigen eine weitere Ausbildung der Positionsmarkierungen eines Gleitschalters 1". Dieser Gleitschalter ist im Wesentlichen identisch zu den bereits beschriebenen Gleitschaltern aufgebaut. Im Folgenden werden daher nur die Unterschiede erläutert. Auf der Vorderseite 3 der Grundplatte 2 ist ein umlaufender, vorstehender Rahmen 14 angebracht. Der Rahmen 14 umrandet die Schaltfläche 4". Der Rahmen 14 ist durch Querstreben 15 in einzelne Bereiche 16 unterteilt. Jeder Bereich 16 wird also von einem vorstehenden Rahmen umgeben. In jedem dieser Bereiche 16 ist ein kugelsegmentförmiger Vorsprung 13 angeordnet. Die kugelsegmentförmigen Vorsprünge 13 haben die gleiche Form und sind im gleichen Abstand zueinander angeordnet. Allerdings ist jeder der Vorsprünge 13 in dem jeweiligen Bereich 16 an einer anderen Stelle angeordnet. Somit bilden der Rahmen jedes Bereichs 16 und der entsprechende Vorsprung 13 eine Positionsmarkierung aus, die in Bezug auf die anderen Positionsmarkierungen an der Schaltfläche 4" haptische Unterschiede aufweist.

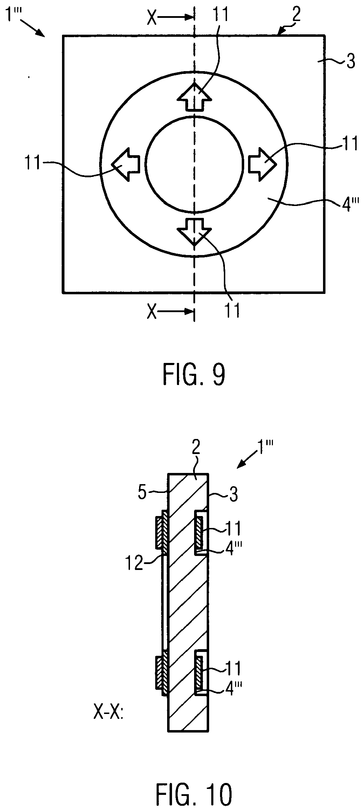

Noch eine weitere Ausführungsform eines Gleitschalters 1'" ist in Fig. 9 gezeigt. Auch der Gleitschalter 1"' umfasst eine Grundplatte 2 mit einer Vorderseite 3 und einer Rückseite 5. Auf der Vorderseite 3 der Grundplatte 2 ist die Schaltfläche 4'" des Gleitschalters 1"' ausgebildet. Die Schaltfläche 4'" ist kreisringförmig und somit als umlaufende Gleitbahn ausgebildet. Dadurch ist ein schnelles kontinuierliches Einstellen des Sollwerts des einzustellenden Parameters möglich.

Die Schaltfläche 4'" weist unterschiedliche Oberflächenrauhigkeiten auf. Dadurch werden haptische Merkmale bzw. haptische Strukturen ausgebildet auf, die eine Positionskennzeichnung ermöglichen. Die Oberflächenrauhigkeit der Schaltfläche ist also so ausgebildet, dass die Schaltfläche 4'" an mindestens zwei Positionen unterschiedliche Oberflächenrauhigkeit aufweist.

In die Schaltfläche 4'" sind berührungsempfindliche Tasten 11 integriert. Die berührungsempfindlichen Tasten sind vorzugsweise ebenfalls als berührungsempfindliche Sensoren ausgebildet, beispielsweise kapazitive, induktive oder resistive Sensoren. Die zugehörige Elektronik 12 ist auf der Rückseite 5 der Grundplatte 2 befestigt. Die Position der Tasten 11 in der Schaltfläche 4'" weist eine Kennzeichnung auf, so dass ein Benutzer die Tasten 11 sofort erkennt. Wie in Fig. 10 zu sehen, sind die Kennzeichnungen als Vorsprünge in der Schaltfläche 4 ausgebildet und bilden daher ebenfalls eine haptische Struktur, die der Benutzer ertasten kann.

Es kann auch vorgesehen sein, die Tasten 11 nicht durch haptische Merkmale sondern durch eine farbige Gestaltung auf der Grundplatte 2 zu kennzeichnen. Es können auch zusätzliche Leuchtdioden an der Rückseite der Grundplatte 2 befestigt werden, die die Position der Tasten 11 kennzeichnen. Ferner können auch Kombinationen dieser Möglichkeiten vorgesehen sein. So können die Tasten 11 beispielsweise durch farbige, haptische Merkmale gekennzeichnet sein, durch eine farbige Kennzeichnung in Kombination mit Leuchtdioden, durch haptische Merkmale in Kombination mit Leuchtdioden oder durch alle drei Merkmale.

Bei allen beschriebenen Gleitschaltern kann vorgesehen werden, dass die Position der Schaltfläche durch Leuchtdioden gekennzeichnet ist. Vorzugsweise sind die Leuchtdioden so ausgebildet, dass sie ihre Farbe wechseln, wenn ein angeordneter Bereich der Schaltfläche des Gleitschalters berührt wird.

Die Form der Schaltfläche des Gleitschalters ist nicht auf die gezeigten Formen beschränkt. So kann die Schaltfläche beispielsweise auch eine ovale, dreieckige oder quadratische Ringform aufweisen.

## Patentansprüche

1. Berührungsempfindlicher Gleitschalter (1, 1.4, 1.5) mit einer Schaltfläche (4, 4.4, 4.5), die haptische Merkmale (6) aufweist, wobei der Gleitschalter (1, 1.4, 1.5) derart ausgebildet ist, dass er eine Berührung und/oder Bewegung auf der Schaltfläche (4, 4.4, 4.5) in ein elektrisches Signal umwandelt, **dadurch gekennzeichnet, dass** die haptischen Merkmale (6) auf der Schaltfläche als Querrippen ausgebildet sind, wobei der Abstand zwischen den Querrippen in Längsrichtung (L) der Schaltfläche abnimmt, sodass der Benutzer durch Ertasten erkennt, an welcher Position des Gleitschalters sich sein Finger auf der Schaltfläche befindet, und ob er somit den Sollwert für den einzustellenden Parameter erhöht oder verringert.

2. Gleitschalter (1.4, 1.5) nach Anspruch 1, **dadurch gekennzeichnet, dass** die Position der Schaltfläche (4.4, 4.5) an dem Gleitschalter (1.4, 1.5) mittels Leuchtdioden (17, 18) gekennzeichnet ist.

3. Gleitschalter (1.4, 1.5) nach Anspruch 2, **dadurch gekennzeichnet, dass** die Schaltfläche (4.4, 4.5) in Bereiche aufgeteilt ist, denen jeweils mindestens eine Leuchtdiode (17, 18) zugeordnet ist, und die Leuchtdioden (17, 18) bei Berührung der zugeordneten Bereiche der Schaltfläche (4.4, 4.5) ihre Farbe wechseln.

4. Gleitschalter (1, 1.4, 1.5) nach einem der Ansprüche 1 bis 3, **dadurch gekennzeichnet, dass** die Schaltfläche (4, 4.4, 4.5) auf der Vorderseite (3) einer Grundplatte (2, 2.4, 2.5) des Gleitschalters (1, 1.4, 1.5) angeordnet ist und die Schaltfläche (4, 4.4, 4.5) von der Vorderseite (3) der Grundplatte (2, 2.4, 2.5) hervorgehoben ist.

5. Gleitschalter (1) nach Anspruch 4, **dadurch gekennzeichnet, dass** die Schaltfläche (4,) als Vertiefung in der Grundplatte (2) ausgebildet ist.

6. Gleitschalter (1,) nach einem der Ansprüche 1 bis 5, **dadurch gekennzeichnet, dass** die Schaltfläche (4) als beidseitig begrenzte Gleitstrecke ausgebildet ist.

## Claims

1. Touch-sensitive slide switch (1, 1.4, 1.5) comprising a switching surface (4, 4.4, 4.5) having haptic characteristics (6), wherein the slide switch (1, 1.4, 1.5) is configured such that it converts contact and/or movement on the switching surface (4, 4.4, 4.5) into an electrical signal, **characterized in that** the haptic characteristics (6) on the switching surface are configured as transverse ribs, wherein the distance between the transverse ribs decreases in longitudinal direction (L) of the switching surface, so that the user recognizes by touching at which position of the slide switch his finger is positioned on the switching surface and whether he thus increases or decreases the target value for the parameter to be set.

2. Slide switch (1.4, 1.5) according to claim 1, **characterized in that** the position of the switching surface (4.4, 4.5) on the slide switch (1.4, 1.5) is marked by way of light-emitting diodes (17, 18).

3. Slide switch (1.4, 1.5) according to claim 2, **characterized in that** the switching surface (4.4, 4.5) is divided into areas each having assigned thereto at least one light-emitting diode (17, 18), and the light-emitting diodes (17, 18) change their color upon contact of the assigned areas of the switching surface (4.4, 4.5).

4. Slide switch (1, 1.4, 1.5) according to any one of claims 1 to 3, **characterized in that** the switching surface (4, 4.4, 4.5) is arranged on the front side (3) of a base plate (2, 2.4, 2.5) of the slide switch (1, 1.4, 1.5) and the switching surface (4, 4.4., 4.5) is elevated from the front side (3) of the base plate (2, 2.4, 2.5).

5. Slide switch (1) according to claim 4, **characterized in that** the switching surface (4) is formed as a recess in the base plate (2).

6. Slide switch (1) according to any one of claims 1 to 5, **characterized in that** the switching surface (4) is configured as a slide path which is bounded at both sides.

## Revendications

1. Commutateur glissant (1, 1.4, 1.5) sensible au toucher, comportant une surface de commande (4, 4.4, 4.5), qui présente des caractéristiques haptiques (6), le commutateur glissant (1, 1.4, 1.5) étant configuré de façon à ce qu'il convertisse un toucher et/ou un mouvement sur la surface de commande (4, 4.4, 4.5) en un signal électrique, **caractérisé en ce que** les caractéristiques haptiques (6) sur la surface de commande sont réalisées sous la forme de nervures transversales, la distance entre les nervures transversales diminuant dans la direction longitudinale (L) de la surface de commande, de sorte que l'utilisateur reconnaît, en palpant, à quelle position du commutateur glissant se trouve son doigt sur la surface de commande, et ainsi s'il augmente ou diminue la valeur de consigne pour le paramètre à régler.

2. Commutateur glissant (1.4, 1.5) selon la revendication 1, **caractérisé en ce que** la position de la surface de commande (4.4, 4.5) sur le commutateur glissant (1.4, 1.5) est caractérisée au moyen de diodes luminescentes (17, 18).

3. Commutateur glissant (1.4, 1.5) selon la revendication 2, **caractérisé en ce que** la surface de commande (4.4, 4.5) est subdivisée en différentes zones auxquelles est associée respectivement au moins une diode luminescente (17, 18), et les diodes luminescentes (17, 18), lorsqu'on touche les zones associées de la surface de commande (4.4, 4.5), changent leur coloration.

4. Commutateur glissant (1, 1.4, 1.5) selon l'une des revendications 1 à 3, **caractérisé en ce que** la surface de commande (4, 4.4, 4.5) est agencée sur le côté avant (3) d'une plaque de base (2, 2.4, 2.5) du commutateur glissant (1, 1.4, 1.5), et la surface de commande (4, 4.4, 4.5) est mise en évidence ou est en relief par rapport au côté avant (3) de la plaque de base (2, 2.4, 2.5).

5. Commutateur glissant (1) selon la revendication 4, **caractérisé en ce que** la surface de commande (4) est réalisée sous forme de creux dans la plaque de base (2).

6. Commutateur glissant (1) selon l'une des revendications 1 à 5, **caractérisé en ce que** la surface de commande (4) est réalisée sous forme de parcours de coulissement délimité des deux côtés.
